# EUROPÄISCHE PATENTSCHRIFT

(11) **EP 2 875 530 B1**
(45) Veröffentlichungstag und Bekanntmachung des Hinweises auf die Patenterteilung: **09.12.2020**
(21) Anmeldenummer: 13739424.3
(22) Anmeldetag: 18.07.2013
(51) Int. Cl.: H01L 31/032, H01L 31/0392

(54) **VERMEIDUNG VON GLASVERBIEGUNG BEI THERMISCHEN VERFAHREN**
PREVENTION OF GLASS BENDING DURING THERMAL PROCEDURES
PRÉVENTION DU PLIAGE DE VERRE DANS LE CADRE D'UN PROCÉDÉ THERMIQUE

(30) Priorität: 19.07.2012 EP 12177106
(43) Veröffentlichungstag der Anmeldung: 27.05.2015
(73) Patentinhaber: (CNBM) Bengbu Design & Research Institute for Glass Industry Co., Ltd., Bengbu (CN)
(72) Erfinder: JOST, Stefan, 81543 München (DE); PALM, Jörg, 80797 München (DE)
(74) Vertreter: Gebauer, Dieter Edmund
(86) Internationale Anmeldenummer: PCT/EP2013/065254
(87) Internationale Veröffentlichungsnummer: WO 2014/013042

(56) Entgegenhaltungen:
- EP-A1- 2 360 721
- EP-B1- 0 662 247
- DE-A1- 19 936 081
- DE-A1-102008 022 784
- US-A1- 2010 236 616
- US-A1- 2012 060 900

## Beschreibung

Die Erfindung betrifft eine Mehrschichtkörperanordnung und ein Verfahren zur Wärmebehandlung eines Mehrschichtkörpers zur Herstellung einer Dünnschichtsolarzelle, mit geringer Verbiegung des Glassubstrats.

Photovoltaische Schichtsysteme zur direkten Umwandlung von Sonnenstrahlung in elektrische Energie sind hinreichend bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphem, mikromorphem oder polykristallinem Silizium, Cadmium-Tellurid (CdTe), Gallium-Arsenid (GaAs) oder Kupfer-Indium-(Gallium)-Selenid-Sulfid (Cu(In,Ga)(S,Se)₂) besonders für Solarzellen geeignet. Der pentanäre Halbleiter Cu(In,Ga) (S,Se)₂ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIGS für Selen, Schwefel oder eine Mischung beider Chalkogene stehen.

Trägersubstrate für Dünnschichtsolarzellen enthalten in vielen Fällen anorganisches Glas. Aufgrund des weitreichend verfügbaren Trägersubstrats und einer einfachen monolithischen Serienverschaltung können großflächige Anordnungen von Dünnschichtsolarzellen kostengünstig hergestellt werden.

Ein mögliches Verfahren zur Herstellung von Dünnschichthalbleitern beispielsweise aus Cu(In,Ga) (S,Se)₂ besteht aus einem Zweistufenprozess. Solche zweistufigen Verfahren sind beispielsweise aus J. Palm et al., "CIS module pilot processing applying concurrent rapid selenization and sulfurization of large area thin film precursors", Thin Solid Films 431-432, S. 414-522 (2003) bekannt. Dabei wird zunächst eine Elektrode aus Molybdän auf ein Substrat, beispielsweise ein Glassubstrat, aufgebracht. Die Molybdänschicht wird beispielsweise mit einem Laser strukturiert. Anschließend werden auf die Molybdänschicht verschiedene Vorläuferschichten aus Kupfer, Indium und Gallium abgeschieden, beispielsweise durch Magnetron-Kathodenzerstäubung. Außerdem werden eine Selen-Schicht und/oder eine Schwefel-Schicht durch thermisches Verdampfen auf der Schichtfolge abgeschieden. Der so entstandene Mehrschichtkörper mit den Vorläuferschichten wird in einem zweiten Prozess wärmebehandelt. Durch die Wärmebehandlung erfolgt die eigentliche Kristallbildung und Phasenumwandlung der Vorläuferschichten zur eigentlichen Halbleiterschicht.

Die Wärmebehandlung erfolgt beispielsweise in In-Line-Anlagen, bei denen die unterschiedlichen Prozessschritte in verschiedenen Kammern erfolgen. Die verschiedenen Kammern werden hintereinander in einer Prozessstraße durchlaufen. In einem vereinfachten Aufbau besteht eine In-Line-Anlage aus einer Ladestation, in der die Anlage mit unbehandelten Mehrschichtkörpern beladen wird. Anschließend werden die Mehrschichtkörper über eine Einschleusekammer in die In-Line-Anlage eingefahren. In verschiedenen Heizkammern werden die Mehrschichtkörper mit Aufheizgeschwindigkeiten bis zu 50 °C/s sehr schnell erwärmt und einem bestimmten Temperaturverlauf ausgesetzt. Die Erwärmung erfolgt beispielsweise durch elektrisch betriebene Heizstrahler. Das Verfahren zur schnellen thermischen Prozessierung von einzelnen Vorläuferschichten zu einer Halbleiterverbindung wird üblicherweise als Rapid Thermal Processing (RTP) bezeichnet. Anschließend wird der Mehrschichtkörper in Kühlkammern und/oder einer Kühlstrecke abgekühlt und aus der Anlage ausgeschleust. Ein Verfahren zur schnellen thermischen Prozessierung von Chalkopyrit-Halbleitern zur Verwendung als Absorber in Dünnschichtsolarzellen ist beispielsweise aus EP 0 662 247 B1 bekannt.

Zur besseren Kontrolle des Wärmebehandlungsprozesses kann der Prozessraum um den Mehrschichtkörper beispielsweise durch eine temporäre Prozessbox begrenzt werden, wie aus DE 10 2008 022 784 A1 bekannt ist. Durch Begrenzung des Prozessraumes bleibt der Partialdruck der leicht flüchtigen Chalkogenkomponenten wie Selen oder Schwefel während der Wärmebehandlung weitestgehend konstant. Außerdem wird die Exposition der Prozesskammer mit korrosiven Gasen reduziert. Verfahren zur Prozessierung von zwei Glassubstraten in einer Prozessbox, sogenannte Dual-Substrate-Verfahren, sind beispielsweise aus EP 2 360 720 A1 und EP 2360721 A1 bekannt.

Aufgrund der hohen Temperaturen findet beim RTP-Prozess oftmals eine unkontrollierte Verbiegung der als Trägersubstrate verwendeten Glassubstrate statt. Die Verbiegung der Glassubstrate ist nachteilig für die weiteren Prozessschritte, so dass eine Weiterprozessierung schwierig oder unmöglich ist.

So wird durch die Vorläuferschichten typischer Weise eine mechanische Druckkraft (Druckspannung) auf das Substrat ausgeübt, welche dazu führt, dass sich die Ränder des Substrats aufbiegen. Dem kann durch eine metallische Rückseitenschicht auf der anderen Substratseite entgegen gewirkt werden. Diese Rückseitenschicht übt eine entsprechende mechanische Druckkraft (Druckspannung) in Gegenrichtung auf das Substrat aus. Eine Rückseitenschicht zum mechanischen Ausgleichen einer durch die Vorläuferschichten verursachten Druckspannung ist in der US-Patentanmeldung Nr. 2012/0060900 A1 beschrieben.

Die Aufgabe der vorliegenden Erfindung liegt darin, eine verbesserte Mehrschichtkörperanordnung bereitzustellen, die bei einer Wärmebehandlung eine verringerte Verbiegung des Glassubstrats aufweist.

Die Aufgabe der vorliegenden Erfindung wird erfindungsgemäß durch eine Mehrschichtkörperanordnung gemäß Anspruch 1 gelöst. Bevorzugte Ausführungen gehen aus den Unteransprüchen hervor.

Des Weiteren umfasst die Erfindung ein Verfahren zum Wärmebehandeln von Mehrschichtkörpern mit verringerter Substratverbiegung.

Eine Verwendung der erfindungsgemäßen Mehrschichtkörperanordnung geht aus weiteren Ansprüchen hervor.

Der Ausdruck Mehrschichtkörper beschreibt im Sinne der Erfindung mindestens ein Substrat und insbesondere ein Glassubstrat mit mehreren darauf aufgebrachten oder in unmittelbarem, thermischem Kontakt angeordneten gleichen oder verschiedenen Schichten.

Die Erfinder haben die folgende überraschende und ursächliche Problemkette erkannt, die zu einer Substratverbiegung während der Wärmebehandlung eines Glassubstrats mit einer einseitigen Beschichtung führt. Wird ein Glassubstrat mit einer einseitigen Beschichtung, beispielsweise einer funktionellen Beschichtung aus einer Barriereschicht, einer Elektrode und Vorläuferschichten, in einem Strahlerfeld erwärmt, so führt dies zu einer inhomogenen Temperaturverteilung über die Substratdicke z. Die funktionelle Beschichtung absorbiert in der Regel mehr Strahlung als das Glassubstrat. Dadurch wird die Seite mit der funktionellen Beschichtung stärker erwärmt als die der Beschichtung abgewandten Seite des Glassubstrats. Die inhomogene Temperaturverteilung führt zu einer unterschiedlichen Ausdehnung von beschichteter Seite und unbeschichteter Seite. Dies führt zu Spannungen in der Anordnung aus Glassubstrat und funktioneller Beschichtung und zu einer Verbiegung des Glassubstrats im heißen Zustand. Wird das Glassubstrat über die Glaserweichungstemperatur von beispielsweise etwa 470°C für Kalk-Natron-Glas erwärmt, so findet aufgrund der Viskoelastizität des Glases eine mechanische Entspannung statt. Die Seite mit der geringeren Erwärmung und damit der geringeren Wärmeausdehnung kann sich durch die Erweichung des Glases und unter dem Eigengewicht des Glassubstrates ausdehnen. Das Glassubstrat liegt nun wieder flach auf beispielsweise einer Bodenplatte auf. Das Glassubstrat weist dabei einen Temperatur-Gradienten zwischen beschichteter und unbeschichteter Seite auf. Kühlt das Glassubstrat nach Abschalten der Strahlungsleistung ab, so führt das zu einer Verbiegung in Gegenrichtung aufgrund der größeren thermischen Kontraktion der heißeren Seite des Glassubstrats. Ist das Glassubstrat unter die Glaserweichungstemperatur abgekühlt, findet keine Entspannung im Glassubstrat mehr statt. Das Glassubstrat zeigt nach der Abkühlung eine ausgeprägte Verbiegung.

Eine derartige Substratverbiegung wird unerwarteterweise durch eine erfindungsgemäße Mehrschichtkörperanordnung vermieden oder verringert.

Die erfindungsgemäße Mehrschichtkörperanordnung zur Vermeidung einer Glassubstratverbiegung umfasst mindestens
- ein Glassubstrat,
- eine funktionelle Beschichtung, die auf einer Seite des Glassubstrats aufgebracht ist, wobei die funktionelle Beschichtung Vorläuferschichten zum Überführen in eine Halbleiterschicht einer Dünnschichtsolarzelle enthält,
- eine Hilfsschicht, die flächig mit der der funktionellen Beschichtung abgewandten Seite des Glassubstrats verbunden ist und
- mindestens ein Strahlerfeld mit einer auf das Glassubstrat einfallenden Strahlungsleistung P_{ges} im Wellenlängenbereich von 250 nm bis 4000 nm zur Wärmebehandlung der funktionellen Beschichtung. Bei einer vorteilhaften Ausgestaltung ist auf beiden Seiten des Glassubstrats jeweils ein solches Strahlerfeld angeordnet.

Die Hilfsschicht weist dabei eine absorbierte Strahlungsleistung P₂₀ von 10% bis 60% der einfallenden Strahlungsleistung P_{ges} auf.
Das Glassubstrat, die funktionelle Beschichtung und die Hilfsschicht bilden einen Mehrschichtkörper.
In einer vorteilhaften Ausgestaltung der erfindungsgemäßen Mehrschichtkörperanordnung ist die Hilfsschicht unmittelbar auf dem Glassubstrat aufgebracht ist, bevorzugt durch Aufdampfen, Kathodenzerstäubung oder elektrochemisches Abscheiden.

In einer vorteilhaften Ausgestaltung der erfindungsgemäßen Mehrschichtkörperanordnung ist die Hilfsschicht mit dem Glassubstrat lösbar verbunden (z.B. hat die Hilfsschicht Berührungskontakt mit dem Glassubstrat, ohne mit dem Glassubstrat fest verbunden zu sein, d.h. die Hilfsschicht ist benachbart zum Glassubstrat, insbesondere in Berührungskontakt mit diesem angeordnet). Die Hilfsschicht ist dann bevorzugt auf einer Trägerplatte aufgebracht. Das Glassubstrat kann auf die Hilfsschicht auf die Trägerplatte geklemmt oder aufgelegt sein. Alternativ kann die Trägerplatte mit der durch die Hilfsschicht beschichteten Seite auf das Glassubstrat aufgelegt oder geklemmt sein. Die Hilfsschicht ist bevorzugt auf eine Bodenplatte oder eine Deckelplatte einer Prozessbox aufgebracht.

Das Glassubstrat, die funktionelle Beschichtung und die Hilfsschicht können ohne Einschränkung der Erfindung mehrere übereinander oder nebeneinander angeordnete Schichten aufweisen.

Die von den Strahlerfeldern einfallende Strahlungsleistung P_{ges} im Wellenlängenbereich von 250 nm bis 4000 nm beträgt bevorzugt von 10 kW/m² bis 500 kW/m² und besonders bevorzugt von 50 kW/m² bis 200 kW/m².

In einer vorteilhaften Ausgestaltung der Erfindung beträgt die von den Strahlerfeldern einfallende Strahlungsleistung P_{ges} im Wellenlängenbereich von 400 nm bis 2500 nm von 10 kW/m² bis 500 kW/m² und bevorzugt von 50 kW/m² bis 200 kW/m².

Die erfindungsgemäße Hilfsschicht absorbiert bevorzugt eine absorbierte Strahlungsleistung P₂₀ von 10% bis 40% und besonders bevorzugt von 20% bis 30% von P_{ges}.

In einer vorteilhaften Ausgestaltung absorbiert die Hilfsschicht eine Strahlungsleistung P₂₀ von 50% bis 150% und bevorzugt von 75% bis 125% der in der funktionellen Beschichtung absorbierten Strahlungsleistung P₁₀.

Die erfindungsgemäße Vorrichtung zum Wärmebehandeln des Mehrschichtkörpers umfasst mindestens ein Strahlerfeld. In einer vorteilhaften Ausgestaltung umfasst die Vorrichtung zwei Strahlerfelder mit einer dazwischen liegenden Prozessebene, in der der Mehrschichtkörper angeordnet ist. Die Strahlerfelder und die Prozessebene sind bevorzugt parallel zueinander angeordnet.

Bei vorteilhaften Ausgestaltungen der erfindungsgemäßen Vorrichtung sind die Strahlerfelder, die Prozessebene und der Mehrschichtkörper vertikal oder horizontal angeordnet. Eine vertikale Anordnung im Sinne der Erfindung bedeutet, dass die Strahlerfelder, die Prozessebene und der Mehrschichtkörper näherungsweise parallel zur Anlagengrundfläche angeordnet sind. In einer horizontalen Anordnung sind Strahlerfelder, Prozessebene und Mehrschichtkörper näherungsweise orthogonal zur Anlagengrundfläche angeordnet.

Die erfindungsgemäße Hilfsschicht ist vorteilhafterweise inert gegen die Prozessprodukte der funktionellen Beschichtung während der Wärmebandlung und insbesondere inert gegen Schwefeldämpfe und Selendämpfe sowie Schwefelwasserstoff und Selenwasserstoff. Die Hilfsschicht enthält bevorzugt mindestens eine Schicht aus Graphit, Siliziumkarbid und/oder Bornitrid, bevorzugt mit einer Schichtdicke von 10 nm bis 10 µm. Dies hat den besonderen Vorteil, dass die Hilfsschicht temperaturstabil und chemisch inert gegen die Prozessprodukte während der Wärmebehandlung ist.

In einer alternativen Ausgestaltung der erfindungsgemäßen Hilfsschicht, enthält die Hilfsschicht eine Absorptionsschicht und eine Schutzschicht. Die Absorptionsschicht ist zwischen Glassubstrat und Schutzschicht angeordnet. Die Absorptionsschicht absorbiert erfindungsgemäß die elektromagnetische Strahlung des Strahlerfelds und kann Materialien enthalten, die durch die Prozessprodukte wie Schwefel oder Selen korrodiert werden. Geeignete Materialien für die Absorptionsschicht sind beispielsweise Metall, bevorzugt Aluminium, Molybdän, Kupfer, Kobalt, Nickel, Titan, und/oder Tantal. Alternativ kann die Absorptionsschicht Halbleiter oder Halbmetallverbindungen enthalten, bevorzugt Siliziumkarbid, Zinkoxid, Cadmiumsulfid, Cadmiumtellurid, Indiumantimonid, Indiumarsenid und/oder Zinkantimonid

Die Schutzschicht schützt die Absorptionsschicht vor korrosiven Prozessprodukten und enthält bevorzugt Siliziumnitrid, Titannitrid, Molybdännitrid, Aluminiumoxid und/oder Aluminiumnitrid.

In einer vorteilhaften Weiterbildung der erfindungsgemäßen Hilfsschicht ist eine Haftschicht zwischen Glassubstrat und Absorptionsschicht angeordnet. Die Haftschicht erhöht die Haftung der Absorptionsschicht am Glassubstrat und enthält beispielsweise Siliziumnitrid und/oder Siliziumoxynitrid.

Haftschicht, Absorptionsschicht und/oder Schutzschicht bilden bevorzugt eine Diffusionssperre gegen Alkalimetalle aus dem Glassubstrat.

In einer weiteren bevorzugten Ausführungsform enthält der zu prozessierende Mehrschichtkörper ein Glassubstrat mit einer Dicke von 1 mm bis 4 mm, bevorzugt von 2 mm bis 3 mm. Das Glas ist bevorzugt eisenarmes Kalk-Natronglas. Derartiges Glas hat eine Glaserweichungstemperatur von etwa 470°C.

Die funktionelle Beschichtung enthält Vorläuferschichten zum Überführen in eine Halbleiterabsorberschicht einer Dünnschichtsolarzelle. Die erfindungsgemäße Mehrschichtkörperanordnung ist prinzipiell zur Wärmebehandlung von allen Vorläuferschichten, die in Halbleiterabsorberschichten von Dünnschichtsolarzellen überführt werden sollen, geeignet und vermindert dort eine Verbiegung des Glassubstrats.

Zur Herstellung einer Cu(In,Ga) (S,Se)₂-Dünnschichtsolarzelle, enthält die funktionelle Beschichtung bevorzugt mindestens eine Alkali-Diffusionsbarriereschicht aus Siliziumnitrid, eine Elektrodenschicht aus Molybdän, eine Vorläuferschicht aus Kupfer-Indium-Gallium und eine weitere Vorläuferschicht aus Selen. Die Siliziumnitrid-Schicht hat eine Dicke von beispielsweise 50nm bis 300nm, die Molybdän-Schicht von beispielsweise 200 nm bis 700 nm, die Kupfer-Indium-Galium-Schicht von beispielsweise 300 nm bis 1000 nm und die Selen-Schicht von beispielsweise 700 nm bis 2000 nm.

In einer bevorzugten Ausgestaltung der erfindungsgemäßen Vorrichtung befindet sich mindestens ein Mehrschichtkörper, bevorzugt zwei Mehrschichtkörper in einer Prozessbox angeordnet. Die Prozessbox dient zur Begrenzung des Prozessraumes.

Die Prozessbox kann als Kasten mit Boden, Deckel und Seitenwänden ausgestaltet sein. Die Seitenwände können Metall, Glas, Keramik, Glaskeramik oder Graphit enthalten. Boden und Deckel sind bevorzugt transparent oder teilweise transparent, insbesondere für die elektromagnetische Strahlung der Strahlerfelder.

Die Prozessboxen können quasi gasdicht oder offen ausgestaltet sein. Die Prozessboxen können bevorzugt eigene Gasanschlüsse aufweisen und während bestimmter Prozessschritte mit einer bestimmten Gasatmosphäre versehen werden. Die Gasatmosphäre kann beispielsweise reaktive Gase wie H₂S, H₂Se, S-Dampf, Se-Dampf oder H₂ sowie Inertgase wie N₂, He oder Ar enthalten.

Quasi gasdicht bedeutet im Sinne der Erfindung, dass die Prozessbox bis zu einer definierten maximalen Druckdifferenz zwischen dem Innenraum der Prozessbox und der Prozesskammer gasdicht ist. Bei Überschreiten einer definierten maximalen Druckdifferenz kommt es zu einem Druckausgleich zwischen dem Innenraum der Prozessbox und der Prozesskammer. In einer hierfür geeigneten Ausgestaltung wird der Deckel lose auf den Rahmen der Prozessbox aufgelegt. In Abhängigkeit von der Dichtigkeit der Prozessbox kann bei quasi gasdichten Prozessboxen ein Druckunterschied zwischen Innenraum der Prozessbox und der Prozesskammer aufrechterhalten werden. Der freie Austausch von Prozessgas bleibt begrenzt und es bildet sich ein Partialdruckgefälle des Prozessgases.

In einer bevorzugten Ausgestaltung der erfindungsgemäßen Vorrichtung wird eine Prozessbox mit jeweils zwei Mehrschichtkörpern beladen. Zur Prozessierung von zwei Mehrschichtkörpern in einer Prozessbox können beide Glassubstrate derart nebeneinander angeordnet werden, dass beide funktionelle Beschichtungen nach außen zeigen. Alternativ können beide funktionelle Beschichtungen zueinander gewandt sein. Im zueinander gewandten Fall werden vorzugsweise die beiden funktionellen Beschichtungen durch Beabstandungsmittel voneinander getrennt, so dass in den entstandenen Raum ein Prozessgas zugeführt werden kann.

In der vorteilhaften Ausgestaltung der erfindungsgemäßen Anordnung werden die Mehrschichtkörper oder die mit Mehrschichtkörpern beladenen Prozessboxen durch einen Transportmechanismus durch die Vorrichtung gefahren. Der Transportmechanismus kann beispielsweise ein Förderband, Förderketten oder einen Schlittenzug enthalten. Der Transportmechanismus kann bevorzugt Rollen enthalten, die besonders bevorzugt über Keilriemen oder Kettenantriebe, bevorzugt mit außerhalb der Prozesskammer liegender Antriebseinheit, synchron angetrieben werden.

In einer bevorzugten Ausgestaltung der erfindungsgemäßen Vorrichtung enthalten die Strahlerfelder an sich bekannte Linearstrahler, insbesondere elektrisch betriebene stabförmige Infrarotstrahler und/oder eine Matrix aus an sich bekannten Punktstrahlquellen. Die Linearstrahler liegen bevorzugt parallel nebeneinander. Linearstrahler und Punktstrahlquellen sind dazu geeignet eine nahezu gleichmäßige flächige elektromagnetische Strahlung im Wellenlängenbereich von 250 nm bis 4000 nm und bevorzugt im Wärmestrahlungsbereich abzustrahlen.

In einer Ausgestaltung der erfindungsgemäßen Vorrichtung strahlt jedes Strahlerfeld eine elektromagnetische Strahlung gleicher Intensität nach beiden Seiten ab. In einer bevorzugten Ausgestaltung der erfindungsgemäßen Vorrichtung weisen die Strahlerfelder richtungsabhängige Abstrahlcharakteristika auf, insbesondere in Richtung der Prozessebene. Dazu werden beispielsweise Linearstrahler verwendet, die eine einseitige reflektierende Beschichtung aufweisen, beispielsweise aus Keramik, Metall oder nanoporösem opaken Quarzglas, wie aus DE 10 2005 058819 A1 bekannt ist.

In einer weiteren bevorzugten Ausgestaltung der erfindungsgemäßen Vorrichtung umfasst das Strahlerfeld, das sich zwischen zwei Prozessebenen befindet, zwei untereinander angeordnete Ebenen von Linearstrahlern oder Punktstrahlquellen. Zwischen beiden Ebenen ist bevorzugt ein weiterer Reflektor angeordnet. Beide Ebenen können getrennt voneinander geheizt werden. Verschiedene Prozessebenen können so auf unterschiedliche Temperaturen geheizt werden.

Durch Strahlerfelder mit unterschiedlicher Leistung oder Strahlerfelder mit richtungsabhängiger Abstrahlcharakteristik können insbesondere verschiedene Seiten eines Mehrschichtkörpers mit unterschiedlichen Wärmeeinträgen geheizt werden. Durch diese Maßnahme lässt sich die erfindungsgemäße Symmetrisierung der Temperaturverteilung in Richtung der Schichtdicke durch das Glassubstrat unterstützen.

Die Aufgabe der Erfindung wird des Weiteren durch ein Verfahren zur Wärmebehandlung eines Glassubstrats mit funktioneller Beschichtung gelöst, wobei in einem ersten Schritt die funktionelle Beschichtung auf eine Seite des Glassubstrats aufgebracht wird. Des Weiteren wird die der funktionellen Beschichtung abgewandte Seite des Glassubstrats mit einer Hilfsschicht verbunden.

Dabei kann die Hilfsschicht unmittelbar auf dem Glassubstrat aufgebracht werden, beispielsweise durch Aufdampfen, Kathodenstrahlzerstäubung chemische Gasphasenabscheidung, Elektrodeposition oder Sprühverfahren.

Alternativ kann die Hilfsschicht auf einem Trägermaterial wie einer Trägerplatte angeordnet sein, und das Glassubstrat mit der Hilfsschicht des Trägermaterials verbunden werden, beispielsweise durch Klemmen oder Auflegen.

In einem zweiten Schritt wird das Glassubstrat mit der funktionellen Beschichtung und der Hilfsschicht in einem Strahlerfeld auf eine Temperatur oberhalb der Glaserweichungstemperatur des Glassubstrats erwärmt. Die Prozesstemperatur beträgt bevorzugt von 470°C bis 600°C. Vorteilhaft wird das Glassubstrat in einer zwischen zwei Strahlerfeldern liegenden Prozessebene angeordnet und mit einer auf das Glassubstrat einfallenden Strahlungsleistung P_{ges} im Wellenlängenbereich von 250 nm bis 4000 nm auf eine Temperatur von 470°C bis 600°C erwärmt.

In einem dritten Schritt wird das Glassubstrat auf eine Temperatur unterhalb der Glaserweichungstemperatur abgekühlt. Die Glaserweichungstemperatur von eisenarmen Kalk-Natronglas beträgt etwa 470°C.

Eine bevorzugte Verwendung der erfindungsgemäßen Mehrschichtkörperanordnung ist die Umwandlung von Vorläuferschichten in eine Halbleiterschicht, bevorzugt bei Temperaturen von 470°C bis 600°C. Die Halbleiterschicht wird vorzugsweise als Absorber in einer Dünnschichtsolarzelle verwendet.

Die Vorläuferschichten enthalten oder bestehen vorzugsweise aus Kupfer, Indium, Gallium und Selen und werden in einer schwefelhaltigen Atmosphäre durch Rapid Thermal Processing (RTP) in eine Cu(In,Ga) (S,Se)₂-Halbleiterschicht umgewandelt.

Im Folgenden wird die Erfindung anhand von Figuren näher erläutert. Diese sind rein schematische Darstellungen und nicht maßstabsgetreu. Diese schränken die Erfindung in keiner Weise ein.

Es zeigen:
- Figur 1: eine schematische Querschnittsdarstellung einer erfindungsgemäßen Mehrschichtkörperanordnung,
- Figur 2a: einen Querschnitt durch einen erfindungsgemäßen Mehrschichtkörper mit Temperaturprofil,
- Figur 2b: einen Querschnitt eines Mehrschichtkörper nach dem Stand der Technik mit Temperaturprofil,
- Figur 3: einen Querschnitt durch eine Ausgestaltung des erfindungsgemäßen Mehrschichtkörpers,
- Figur 4: einen Querschnitt durch eine weitere Ausgestaltung der erfindungsgemäßen Mehrschichtkörpers,
- Figur 5: einen Querschnitt durch eine weitere Ausgestaltung der erfindungsgemäßen Mehrschichtkörpers,
- Figur 6: einen Querschnitt durch eine weitere Ausgestaltung der erfindungsgemäßen Mehrschichtkörpers und
- Figur 7: ein Ausführungsbeispiel der erfindungsgemäßen Verfahrensschritte anhand eines Flussdiagramms.

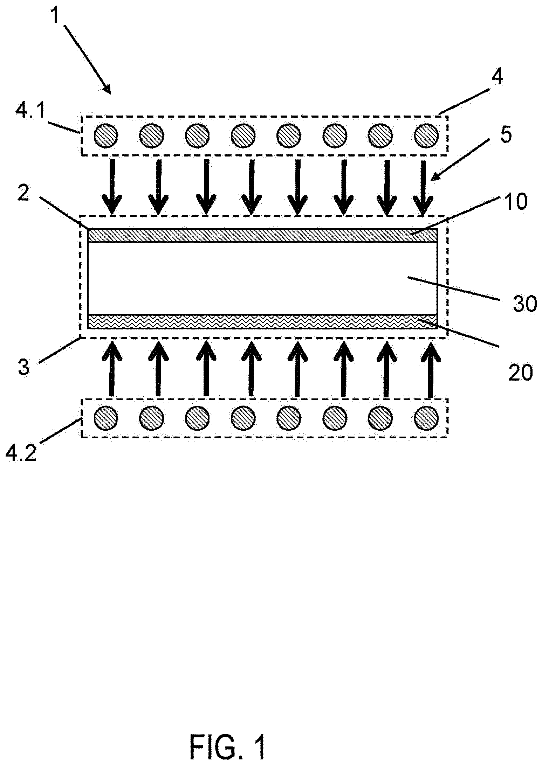

Figur 1 zeigt eine erfindungsgemäße Mehrschichtkörperanordnung 1 zur Wärmebehandlung einer funktionellen Beschichtung 10 auf einem Glassubstrat 30. Die Mehrschichtkörperanordnung 1 ist beispielsweise ein Teil einer hier nicht dargestellten Heizkammer einer In-Line-Anlage zur Wärmebehandlung einer funktionellen Beschichtung 10 aus Vorläuferschichten einer Dünnschichtsolarzelle durch Rapid Thermal Processing (RTP). Die In-Line-Anlage weist des Weiteren eine Kühlkammer auf, die in Transportrichtung hinter der Heizkammer angeordnet ist. Der Mehrschichtkörper 2 befindet sich auf einer Prozessebene 3 die zwischen zwei Strahlerfeldern 4.1 und 4.2 angeordnet ist. Die Strahlerfelder 4.1 und 4.2 umfassen beispielsweise mehrere parallel angeordnete Linearstrahler.

Der Mehrschichtkörper 2 enthält beispielsweise ein Glassubstrat 30 mit einer funktionellen Beschichtung 10 auf der oberen Seite des Glassubstrats 30. Die funktionelle Beschichtung 10 enthält beispielsweise eine Molybdän-Elektrode und eine Stapelfolge von Vorläuferschichten, die Kupfer, Indium, Gallium, Schwefel und Selen enthalten.

Die funktionelle Beschichtung 10 kann gleichwohl auf der unteren Seite des Glassubstrats 30 und die Hilfsschicht 20 auf der oberen Seite des Glassubstrats 30 angeordnet sein. Der Mehrschichtkörper 2 kann auch vertikal stehend zwischen den Strahlerfeldern 4.1 und 4.2 angeordnet sein.

Der Mehrschichtkörper 2 wird durch Strahlung der Leistung Pₒ des oberen Strahlerfelds 4.1 und Pᵤ des unteren Strahlerfelds 4.2 aufgeheizt. Die verschiedenen Schichten des Mehrschichtkörpers 2, das heißt die funktionelle Beschichtung 10, das Glassubstrat 30 und die Hilfsschicht 20, haben bezüglich der einfallenden Strahlung definierte Absorptionskoeffizienten A₁₀, A₂₀ und A₃₀, Reflexionskoeffizienten R₁₀, R₂₀ und R₃₀ und Transmissionskoeffizienten T₁₀, T₂₀ und T₃₀. Bei Verwendung unterschiedlicher Strahlungsquellen oder bei unterschiedlichen Eigenschaften der Oberseiten und Unterseiten der einzelnen Schichten können sich diese Koeffizienten für Strahlung vom oberen Strahlerfeld 4.1 beziehungsweise vom unteren Strahlerfeld 4.2 unterscheiden. Aus Gründen der Darstellung wird hier vereinfacht angenommen, dass diese Koeffizienten identisch für die vom oberen Strahlerfeld 4.1 und unteren 4.2 Strahlerfeld ausgehende Strahlung der Leistung Pₒ und Pᵤ sind.

In Tabelle 1 ist die in den einzelnen Schichten absorbierte Strahlungsleistung, ausgehend vom oberen 4.1 und unteren 4.2 Strahlerfeld angegeben. Die gesamte absorbierte Strahlungsleistung in der jeweiligen Schicht, die durch die Strahlung des oberen Strahlerfelds 4.1 und unteren 4.2 Strahlerfeldes hervorgerufen wird, ist in der rechten Spalte der Tabelle 1 dargestellt.

**Tabelle 1**

| | Absorbierte Leistung aus oberem Strahlerfeld 4.1 mit Leistung Po | Absorbierte Leistung aus unterem Strahlerfeld 4.2 mit Leistung Po | Gesamte absorbierte Leistung |
|---|---|---|---|
| funktionelle Beschichtung 10 | Pₒ x A₁₀ | Pᵤ X T₂₀ X T₃₀ x A₁₀ | P₁₀ = (Pₒ x A₁₀) + (Pᵤ x T₂₀ x T₃₀ x A₁₀) |
| Substrat 30 | Pₒ x T₁₀ x A₃₀ | Pᵤ X T₂₀ X A₃₀ | P₃₀ = (Pₒ x T₁₀ x A₃₀) + (Pᵤ X T₂₀ X A₃₀) |
| Hilfsschicht 20 | Pₒ x T₁₀ x T₃₀ x A₂₀ | Pᵤ X A₂₀ | P₂₀ = (Pₒ x T₁₀ x T₃₀ x A₂₀) + (Pᵤ x A₂₀) |

Ein idealer erfindungsgemäßer Mehrschichtkörper 2 ist nun charakterisiert durch die Bedingung P₁₀ = P₂₀, das heißt die gesamte absorbierte Leistung P₁₀ der funktionellen Beschichtung 10 ist gleich der gesamten absorbierten Leistung P₂₀ der Hilfsschicht 20.

Der beschriebene Idealfall ist in der Realität schwer einzustellen. Eine erfindungsgemäße Verringerung der Substratverbiegung durch eine Symmetrisierung des Temperaturgradienten im Glassubstrat 30 kann allerdings in allen Fällen erreicht werden, wenn die absorbierte Leistung P₂₀ der funktionellen Beschichtung 20 folgenden Bedingungen genügt:
Für P₁₀ > P₃₀ muss gelten P₂₀ > P₃₀ oder
für P₁₀ < P₃₀ muss gelten P₂₀ < P₃.

Die Bedingungen gelten auch für den Fall, dass nur ein Strahlerfeld pro Substrat zur Verfügung steht, bzw. die Strahlungsleistung Pₒ und Pᵤ (Ober- und Unterseite) unterschiedlich ist. Ebenfalls gelten die Bedingungen bei unterschiedlichen Wellenlängen-Maxima von oberem Strahlerfeld 4.1 und unterem Strahlerfeld 4.2.

Die funktionelle Beschichtung 10 und die Hilfsschicht 20 können jeweils auch aus mehreren Schichten bestehen. Die aufgeführten Bedingungen gelten dann für die Absorptions-, Reflexions- und Transmissionseigenschaften des Gesamtpaketes aus funktioneller Beschichtung 10 beziehungsweise Hilfsschicht 20.

Vorteilhaft ist, wenn die Reflektion R₂₀ der Hilfsschicht 20 möglichst gering ist. Für die erfindungsgemäße Verringerung der Verbiegung ist gemäß den oben genannten Bedingungen nur die wirklich absorbierte Leistung wesentlich. Es könnten daher auch Schichten mit höherer Reflektion verwendet werden. In diesem Fall erhöht sich jedoch die für den thermischen Prozess notwendige Heizleistung. Für die Praxis interessante Werte für die Reflektion R₂₀ beginnen zum Beispiel bei R₂₀<70%. Einen nennenswerten Beitrag zu Verringerung der Substratverbiegung wird schon für Absorptionswerte A₂₀ der Hilfsschicht 20 von A₂₀>5% erwartet.

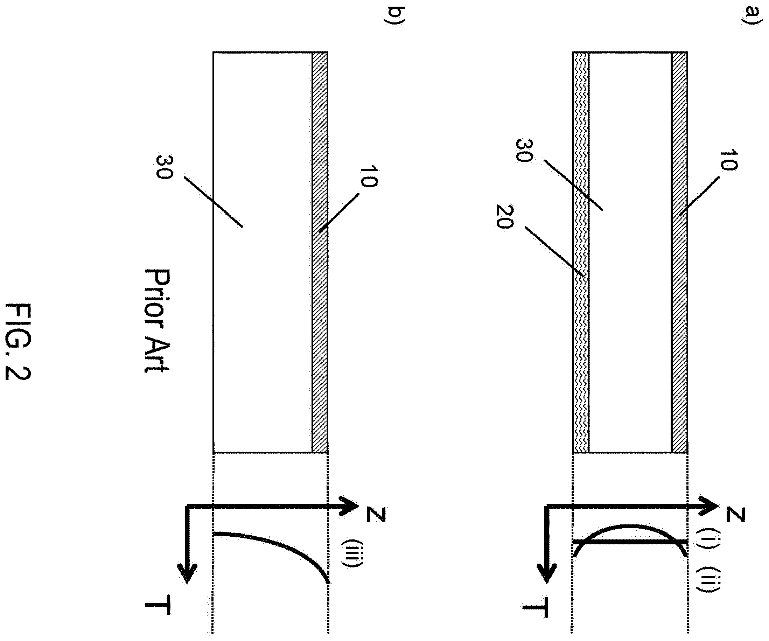

Figur 2a zeigt eine schematische Darstellung des Verlaufs der Temperatur T über die Substrathöhe z des Glassubstrats 30 während der Wärmebehandlung in einem Strahlerfeld gemäß Figur 1. Figur 2a zeigt den Temperaturverlauf über einen Mehrschichtkörper 2 nach Figur 1. Absorbieren funktionelle Beschichtung 10, Hilfsschicht 20 und Glassubstrat 30 etwa jeweils die gleiche Leistung, das heißt P₁₀ = P₂₀ = P₃₀, so ergibt sich ein konstanter Temperaturverlauf (i) über die Substrathöhe z. Wegen der niedrigeren Strahlungsabsorption A₃₀ des Glassubstrats 30 im Vergleich zur Strahlungsabsorption A₁₀ der funktionellen Beschichtung 10 ist dieser Fall nur sehr schwer zu erreichen. Eine Verringerung der Verbiegung des Glassubstrats 30 ergibt sich aber schon durch eine Symmetrisierung des Temperaturverlaufs wenn P₁₀ > P₃₀ mit P₂₀ > P₃₀ gilt. Die resultierende Temperaturverteilung ii) zeigt Temperaturmaxima im Bereich des Glassubstrats 30 an den Grenzen zur funktionellen Beschichtung 10 und zur Hilfsschicht 20.

Figur 2B zeigt den Temperaturverlauf eines Glassubstrats 30 mit einer einseitigen funktionellen Beschichtung 20 nach dem Stand der Technik ohne Hilfsschicht 20. Der Temperaturverlauf ist asymmetrisch und inhomogen. Insbesondere ist die Temperatur T im Bereich der funktionellen Beschichtung 20 höher als auf der Unterseite des Glassubstrats 30, an der sich keine Beschichtung befindet. Nach dem Abkühlen ist eine deutliche Verbiegung des Glassubstrats 30 aufgrund der eingangs beschriebenen Problemkette festzustellen.

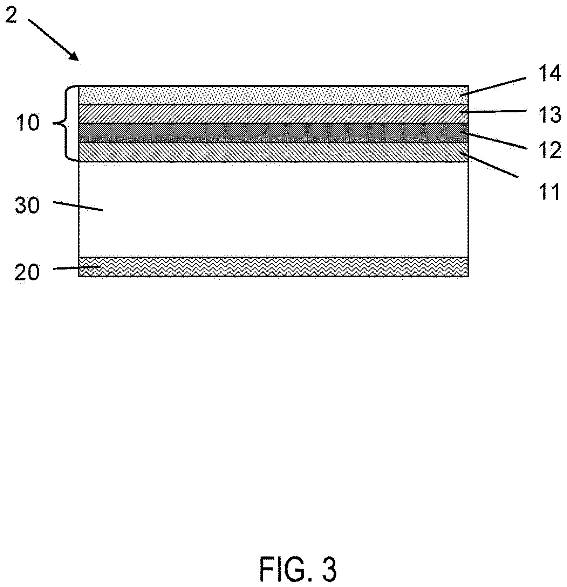

Figur 3 zeigt eine bevorzugte Ausgestaltung des erfindungsgemäßen Mehrschichtkörpers 2. Die funktionale Beschichtung 10 enthält eine Barriereschicht 11 aus Siliziumnitrid, die als Diffusionssperre für Natrium-Ionen aus dem Glassubstrat 30 dient. Des Weiteren enthält die funktionelle Beschichtung 10 eine Elektrode 12, die beispielsweise Molybdän enthält oder aus Molybdän besteht. Auf der Elektrode 12 ist eine Vorläuferschicht 13 aus einer Schichtfolge oder einer Legierung, die Kuper, Indium und/oder Gallium enthält sowie eine weitere Vorläuferschicht 14 aus Selen angeordnet. Die Vorläuferschicht 13 kann durch Wärmebehandlung in eine Absorberschicht einer Dünnschichtsolarzelle überführt werden, beispielsweise in einer schwefelhaltigen Atmosphäre. Die Dicke der Barriereschicht 11 aus Siliziumnitridschicht beträgt bevorzugt von 50 nm bis 300 nm und beispielsweise 150 nm. Die Dicke der Elektrode 12 beträgt bevorzugt von 200 nm bis 700 nm und beispielsweise 500 nm. Die Dicke der Vorläuferschicht 13 beträgt bevorzugt von 300 nm bis 1000 nm und beispielsweise 700 nm. Die Dicke der weiteren Schicht 14 aus Selen beträgt bevorzugt von 700 nm bis 2000 nm und beispielsweise 1500 nm. Andere Materialien für die Barrierenschicht 11 sind beispielsweise Siliziumoxynitrid, Aluminiumoxid, Molybdännitrid, Titannitrid oder Gemische oder Schichtfolgen davon. Die Elektrode 12 enthält bevorzugt Kupfer, Aluminium, Titan oder Gemische oder Schichtfolgen davon. Die Vorläuferschicht 13 kann auch Aluminium, Schwefel, Zink, Zinn oder Silber enthalten.

Auf der der funktionellen Beschichtung 10 abgewandten Seite des Glassubstrats 30 ist eine Hilfsschicht 20 angeordnet. Eine wichtige Bedingung für die Hilfsschicht 20 ist die chemische und thermische Stabilität. Die Hilfsschicht 20 besteht in diesem Ausgestaltungsbeispiel aus einer einzelnen (teil-)absorbierenden und gegen die Prozessprodukte der Vorläuferschichten 13 und 14 chemisch inerten Schicht. Die Herstellungsverfahren für Cu(In,Ga) (S,Se)₂-Dünnschichtsolarzellen erfordern beispielsweise eine Temperaturstabilität für Temperaturen bis etwa 600°C und eine chemische Stabilität gegenüber Selendampf und Schwefeldampf sowie gegen Schwefelwasserstoff und Selenwasserstoff.

Die Hilfsschicht 20 enthält bevorzugt Graphit, Siliziumnitrid oder Bornitrid. Die Hilfsschicht besteht beispielsweise aus einer Graphitschicht mit einer Dicke von 200 nm.

Die Hilfsschicht 20 hat je nach Herstellung- oder Abscheideverfahren eine Dicke von 10 nm bis 10 µm. Die untere Grenze hängt vom gewünschten Transmissionsgrad und den optischen Eigenschaften der Schicht ab. Die optimale Dicke kann durch einfache Experimente ermittelt werden. Die Abscheidung der Hilfsschicht 20 erfolgt bevorzugt durch Plasma-Verfahren im Vakuum wie Kathodenzerstäubung, durch Verdampfen, durch Chemische Gasphasenabscheidung (chemical vapour deposition CVD) wie Plasma-CVD, durch Elektrodeposition und/oder durch Sprühverfahren.

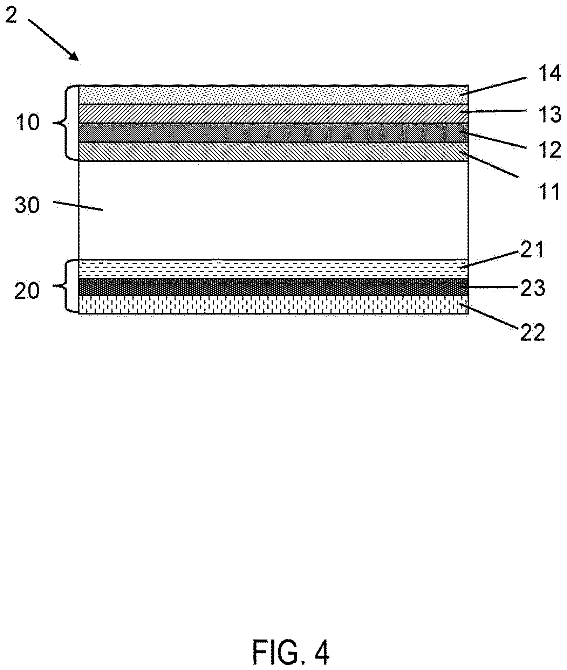

Figur 4 zeigt eine alternative Ausgestaltung eines erfindungsgemäßen Mehrschichtkörpers 2. Die funktionelle Beschichtung 20 entspricht den unter Figur 3 beschriebenen Schichten. Die Hilfsschicht 20 enthält eine Stapelfolge aus einer Haftschicht 21, einer Absorptionsschicht 23 und einer Schutzschicht 22, wobei die erste Barriereschicht 21 direkt benachbart zum Glassubstrat 30 angeordnet ist. Die Haftschicht 21 und Schutzschicht 22 sind im Wesentlichen transparent und enthalten dielektrisches Material. Im Wesentlichen transparent heißt im Sinne dieser Erfindung eine Transmission für die einfallende elektromagnetische Strahlung der Strahlerfelder 4 von mehr als 98%.

Die Schutzschicht 22 ist vorteilhafterweise inert gegen die Prozessprodukte bei der Wärmebehandlung der Vorläuferschichten 13 und 14 und insbesondere inert gegen selen- und/oder schwefelhaltige Atmosphäre bei hohen Temperaturen. Die Haftschicht 21 ist eine haftvermittelnde oder haftungsverbessernde Schicht, die die Absorptionsschicht 13 und die Schutzschicht 22 fest mit dem Glassubstrat 30 verbindet. Vorteilhafterweise enthält die Haftschicht 21 Siliziumnitrid oder Siliziumoxynitrid. Die Dicke der Haftschicht 21 beträgt vorteilhafterweise von 0 nm bis 300 nm. Die Haftschicht 21 ist beispielsweise eine Siliziumnitridschicht.

Die Schutzschicht 22 enthält bevorzugt Siliziumnitrid, Titannitrid, Molybdännitrid, Aluminiumoxid und/oder Aluminiumnitrid. Die Dicke der Schutzschicht 22 beträgt vorteilhafterweise von 50 nm bis 500 nm. Die Schutzschicht 22 ist beispielsweise eine Siliziumnitridschicht mit einer Dicke von 1500 nm.

Derartige Haftschichten 21 und Schutzschichten 22 verhindern die Diffusion von Alkalimetallen aus dem Glassubstrat 30 heraus und in die Vorläuferschichten 13 und 14 hinein. Eine unkontrollierte Diffusion von Alkalimetallen in die Vorläuferschichten 13,14 oder die daraus entstehende Halbleiterabsorberschicht verringert den Wirkungsgrad und verschlechtert die elektrischen Eigenschaften der späteren Dünnschichtsolarzelle.

Als alleinige Hilfsschicht 20 eignen sich einfache Metallschichten nur bedingt, da die Reaktivität mit Selen und Schwefel üblicherweise zu stark ist und die Metallschichten korrodieren. Zudem ist die Reflektion von dünnen und glatten Metallschichten ungünstig hoch.

Wird die Metallschicht durch eine Schutzschicht 22 vor der Prozessatmosphäre geschützt, so können Metallschichten als Absorptionsschicht 23 eingesetzt werden. Als Metalle sind insbesondere Aluminium, Molybdän, Kupfer, Kobalt, Nickel, Titan, Tantal oder Legierungen davon geeignet. Um die Reflexion zu reduzieren, kann es weiterhin vorteilhaft sein, die Metallschicht porös und/oder mit rauer Oberfläche abzuscheiden.

Die Absorptionsschicht 23 kann vorteilhafterweise einen Halbleiter oder ein Halbmetall enthalten. Besonders geeignet sind amorphes Siliziumgermanium, Siliziumkarbid, Zinkoxid, Cadmiumsuilfid, Cadmiumtellurid, Indiumantimonid, Indiumarsenid und/oder Zinkantimonid. Bei diesen Halbleitern lässt sich über die Bandlücke und die Anzahl der freien Ladungsträger das Absorptionsverhalten einstellen und bezüglich der einfallenden Strahlung optimieren. Bei den Halbleitern mit kleiner Bandlücke wie Indiumarsenid und Zinkantimonid liegt die für diese Anwendung interessante Absorption bei elektromagnetischer Strahlung mit Energien oberhalb der Bandlücke. Halbleiter mit großer Bandlücke wie Zinkoxid sind zwar im sichtbaren Bereich transparent, zeigen aber verstärkte Absorption für Wellenlängen oberhalb einer durch die Plasmafrequenz bestimmten kritischen Wellenlänge.

In einer vorteilhaften Ausgestaltung der erfindungsgemäßen Hilfsschicht 20 wird der Brechungsindex und die Schichtdicke der Schutzschicht 22 so eingestellt, dass die Schutzschicht 22 als Antireflexschicht wirkt. Die Schichtparameter sind vorzugsweise so zu wählen, dass das Minimum der Reflektion beim Maximum der Spektralenverteilung der elektromagnetischen Strahlung der Strahlerfelder 4 liegt. Bei einer Schutzschicht 22 aus einer einlagigen Siliziumnitrid-Schicht ist dies beispielsweise ein Schichtdicke von etwa 400 nm. Die Schutzschicht 22 kann auch eine Gradientenschicht mit unterschiedlichem Brechungsindex entlang der Schichtdicke oder wiederum eine dielektrische Mehrfachschicht sein, um die Antireflexwirkung zu erhöhen.

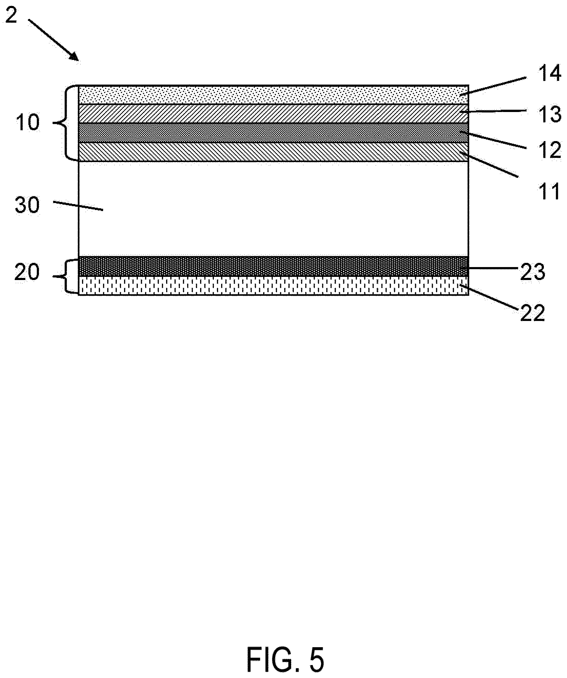

Figur 5 zeigt ein besonders vorteilhaftes Ausgestaltungsbeispiel einer vereinfachten Hilfsschicht 20. Die Hilfsschicht 20 weist eine Absorptionsschicht 23 aus Molybdän und eine Schutzschicht 22 aus Siliziumnitrid auf. Diese Schichtfolge hat den besonderen Vorteil, dass die Absorptionsschicht 23 aus Molybdän gut auf dem Glassubstrat 30 haftet und die Kombination Molybdän/Siliziumnitrid gleichzeitig eine ausreichende Diffusionssperrwirkung für Alkalimetalle aus dem Glassubstrat 30 aufweist.

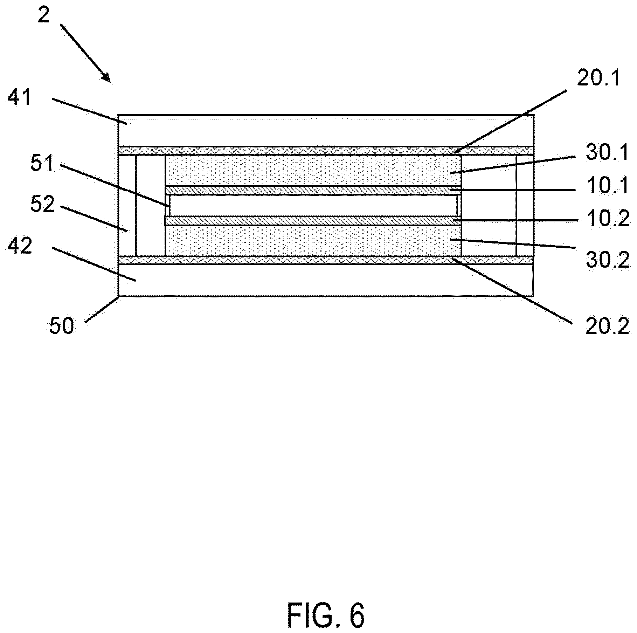

Figur 6 zeigt eine alternative Ausgestaltung einer erfindungsgemäßen Mehrschichtkörperanordnung 1 mit zwei Glassubstraten 30.1 und 30.2 in einer Prozessbox 50. Diese Anordnung wird üblicherweise als Dual Substrate-Konfiguration bezeichnet. Die funktionellen Schichten 10.1 und 10.2 sind hier direkt benachbart zueinander angeordnet (face to face-Konfiguration) und durch Beabstandungselemente 51 auf einen festen Abstand gehalten.

Die Hilfsschichten 20.1 und 20.2 sind beispielsweise auf Trägerplatten 40 wie einer Deckelplatte 41 oder Bodenplatte 42 angeordnet. Ein Rahmenelement 52 bildet mit der Deckelplatte 41 und der Bodenplatte 42 den Prozessraum aus. Die Trägerplatte 40 enthält beispielsweise eine Glaskeramik, die im Wesentlichen transparent für die elektromagnetische Strahlung 5 der Strahlerfelder 4.1 und 4.2 ist.

Die erfindungsgemäße Symmetrisierung des Temperaturgradienten erfolgt hier durch thermischen Kontakt der Hilfsschichten 20.1 und 20.2, die lösbar mit den Glassubstraten 30.1 und 30.2 verbunden sind. Der thermische Kontakt zum unteren Glassubstrat 10.2 erfolgt beispielsweise durch Aufliegen der der funktionellen Beschichtung 10.2 abgewandten Seite des Glassubstrats 30.2 auf die Hilfsschicht 20.2. Die Hilfsschicht 20.2 ist wiederum auf der Bodenplatte 42 der Prozessbox 50 angeordnet. Alternativ erfolgt der thermische Kontakt zum oberen Glassubstrat 10.1 durch Aufliegen der Hilfsschicht 20.1 auf die der funktionellen Schicht 10.1 abgewandten Seite des Glassubstrat 30.1. Die Hilfsschicht 20.1 ist dabei auf der Unterseite der Deckelplatte 41 angeordnet. Die Hilfsschichten 20.1 und 20.2 können Materialien sein, die gegen die Prozessprodukte und insbesondere Schwefel und Selen bei hohen Temperaturen inert sind, wie beispielsweise Graphit, Siliziumkarbid oder Bornitrid, wie unter Figur 3 beschrieben wurde. Die Hilfsschichten 20.1 und 20.2 können aber auch Mehrschichtsysteme aus Absorptionsschichten 23 und Schutzschichten 22 sein, wie sie unter Figur 4 und Figur 5 bereits beschrieben wurden. Es versteht sich, dass die Absorptionsschicht 23 in diesem Fall bevorzugt unmittelbar auf der Trägerplatte 40 angeordnet ist und die Schutzschicht 22 die Absorptionsschicht 23 dem Prozessraum gegenüber abschirmt. Dies hat den besonderen Vorteil, dass die Schutzschicht 22 die Absorptionsschicht 23 vor reaktiven Prozessprodukten und mechanischer Zerstörung bei Berührung mit dem Glassubstrat schützt.

Die vorliegende Erfindung ist nicht auf Anordnungen mit ein oder zwei Glassubstraten 30 eingeschränkt. Des Weiteren können zwei Glassubstrate 30.1 und 30.2 derart angeordnet sein, dass die funktionellen Beschichtungen 10.1 und 10.2 voneinander weg weisen und durch die Glassubstrate 30.1 und 30.2 voneinander getrennt werden (back to back-Konfiguration). Zwischen beiden Glassubstraten 30.1 und 30.2 kann sich eine hier nicht dargestellte Trägerplatte befinden, dass beidseitig mit jeweils einer Hilfsschicht 20 beschichtet ist.

Die Trägerplatte mit der Hilfsschicht 20 muss nicht Teil einer Prozessbox sein, sondern kann beispielsweise der Boden eines Transportbandes sein oder als getrenntes Element einfach nur auf dem Glassubstrat 30 aufliegen.

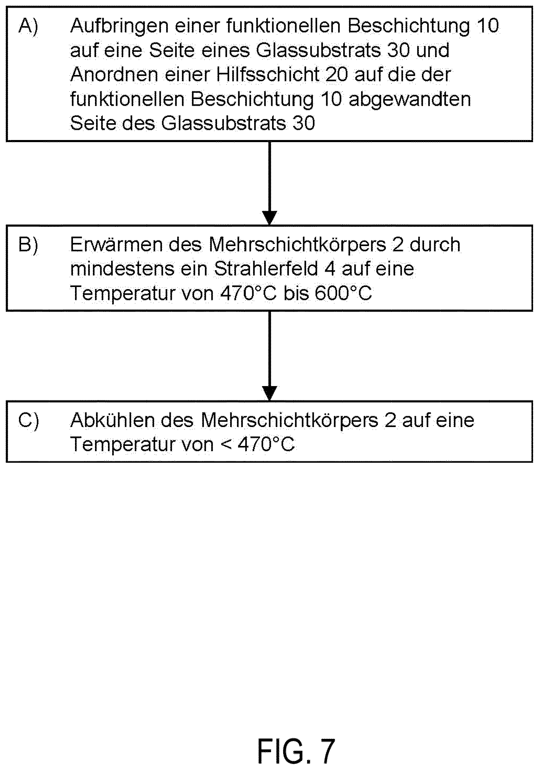

Figur 7 zeigt ein Ausführungsbeispiel der erfindungsgemäßen Verfahrensschritte anhand eines Flussdiagramms.

Glassubstrate 30, deren Temperaturprofil durch eine erfindungsgemäße Hilfsschicht 20 symmetrisiert werden, zeigen nach der Wärmebehandlung eine geringere Verbiegung als gleichartige Glassubstrate 30, die ohne Hilfsschicht 20 prozessiert wurden.

Dieses Ergebnis war für den Fachmann unerwartet und überraschend.

Es zeigen:
- 1: Mehrschichtkörperanordnung
- 2: Mehrschichtkörper
- 3: Prozessebene
- 4, 4.1, 4.2: Strahlerfeld
- 5: elektromagnetische Strahlung
- 10, 10.1, 10.2: funktionelle Beschichtung
- 11: Barriereschicht
- 12: Elektrode
- 13: Vorläuferschicht
- 14: weitere Vorläuferschicht
- 20, 20.1, 20.2: Hilfsschicht
- 21: Haftschicht
- 22: Schutzschicht
- 23: Absorptionsschicht
- 30, 30.1, 30.2: Glassubstrat
- 41: Bodenplatte
- 42: Deckelplatte
- 50: Prozessbox
- 51: Beabstandungselement
- 52: Rahmenelement
- z: Substratdicke
- T: Temperatur

## Patentansprüche

1. Mehrschichtkörperanordnung (1) zur Vermeidung einer Glassubstratverbiegung, umfassend:
- einen Mehrschichtkörper (2) mit einem Glassubstrat (30), einer funktionellen Beschichtung (10), die auf einer Seite des Glassubstrats (30) aufgebracht ist, und einer Hilfsschicht (20), die flächig mit der der funktionellen Beschichtung (10) abgewandten Seite des Glassubstrats (30) verbunden ist, wobei die funktionelle Beschichtung (10) Vorläuferschichten zum Überführen in eine Halbleiterschicht einer Dünnschichtsolarzelle enthält,
- zwei Strahlerfelder (4) mit einer dazwischen liegenden Prozessebene, in der der Mehrschichtkörper (2) angeordnet ist, mit einer auf das Glassubstrat (30) einfallenden Strahlungsleistung P_{ges} im Wellenlängenbereich von 250 nm bis 4000 nm zur Wärmebehandlung der funktionellen Beschichtung (10),
wobei die Hilfsschicht (20) eine absorbierte Strahlungsleistung P20 von 10% bis 60% der einfallenden Strahlungsleistung P_{ges} aufweist.

2. Mehrschichtkörperanordnung (1) nach Anspruch 1, wobei die Hilfsschicht (20) auf dem Glassubstrat (30) aufgebracht ist, bevorzugt durch Aufdampfen, Kathodenzerstäubung oder elektrochemisches Abscheiden.

3. Mehrschichtkörperanordnung (1) nach Anspruch 1, wobei die Hilfsschicht (20) mit dem Glassubstrat (30) lösbar verbunden ist.

4. Mehrschichtkörperanordnung (1) nach Anspruch 3, wobei die Hilfsschicht (20) auf einer Trägerplatte (40), bevorzugt einer Bodenplatte (41) oder einer Deckelplatte (42) einer Prozessbox (50), aufgebracht ist.

5. Mehrschichtkörperanordnung (1) nach einem der Ansprüche 1 bis 4, wobei die Hilfsschicht (20) eine absorbierte Strahlungsleistung P20 von 10% bis 40% und bevorzugt von 20% bis 30% von P_{ges} aufweist.

6. Mehrschichtkörperanordnung (1) nach einem der Ansprüche 1 bis 5, wobei die Hilfsschicht (20) eine absorbierte Strahlungsleistung P20 von 50% bis 150% und bevorzugt von 75% bis 125% der in der funktionellen Beschichtung (10) absorbierten Strahlungsleistung P₁₀ aufweist.

7. Mehrschichtkörperanordnung (1) nach einem der Ansprüche 1 bis 6, wobei die Hilfsschicht (20) mindestens eine Schicht aus Graphit, Siliziumkarbid und/oder Bornitrid, bevorzugt mit einer Schichtdicke von 10 nm bis 10 µm, enthält.

8. Mehrschichtkörperanordnung (1) nach einem der Ansprüche 1 bis 7, wobei die Hilfsschicht (20) eine auf dem Glassubstrat (30) angeordnete Absorptionsschicht (23) und eine auf der Absorptionsschicht (23) angeordnete Schutzschicht (22) enthält.

9. Mehrschichtkörperanordnung (1) nach einem der Ansprüche 1 bis 8, wobei die Absorptionsschicht (23) ein Metall, bevorzugt Aluminium, Molydän, Kupfer, Kobalt, Nickel, Titan und/oder Tantal, oder eine Halbmetallverbindung, bevorzugt Siliziumkarbid, Zinkoxid, Cadmiumsulfid, Cadmiumtellurid, Indiumantimonid, Indiumarsenid und/oder Zinkantimonid, und/oder die Schutzschicht (22) Siliziumnitrid, Titannitrid, Molydännitrid, Aluminiumoxid und/oder Aluminiumnitrid enthält.

10. Mehrschichtkörperanordnung nach einem der Ansprüche 1 bis 9, wobei die Hilfsschicht (20) zwischen Glassubstrat (30) und Absorptionsschicht (23) eine Haftschicht (21) aufweist und die Haftschicht (21) bevorzugt Siliziumnitrid und/oder Siliziumoxynitrid enthält.

11. Mehrschichtkörperanordnung nach einem der Ansprüche 1 bis 10, wobei die funktionelle Beschichtung (10) Vorläuferschichten (13,14) aus Kupfer, Indium, Gallium, Schwefel und/oder Selen enthält.

12. Mehrschichtkörperanordnung nach einem der Ansprüche 1 bis 11, wobei die funktionelle Beschichtung (10) mindestens eine Barriereschicht (11), bevorzugt eine Siliziumnitrid-Schicht mit einer Dicke von 50 nm bis 300 nm, eine Elektrode (12), bevorzugt eine Molybdän-Schicht mit einer Dicke von 200 nm bis 700 nm, eine Vorläuferschicht (13), bevorzugt eine Kupfer-Indium-Gallium-Schicht mit einer Dicke von 300 nm bis 1000 nm und eine weitere Vorläuferschicht (14), bevorzugt eine Selen-Schicht mit einer Dicke von 700 nm bis 2000 nm, enthält.

13. Verfahren zur Wärmebehandlung mit einer Mehrschichtkörperanordnung (1) nach einem der Ansprüche 1 bis 12, wobei
a) auf eine Seite eines Glassubstrats (30) eine funktionellen Beschichtung (10) aufgebracht wird und die der funktionellen Beschichtung (10) abgewandte Seite des Glassubstrats (30) mit einer Hilfsschicht (20) verbunden wird, wobei die funktionelle Beschichtung (10) Vorläuferschichten zum Überführen in eine Halbleiterschicht einer Dünnschichtsolarzelle enthält,
b) das Glassubstrat (30) in einer zwischen zwei Strahlerfeldern (4) liegenden Prozessebene angeordnet und mit einer auf das Glassubstrat (30) einfallenden Strahlungsleistung P_{ges} im Wellenlängenbereich von 250 nm bis 4000 nm auf eine Temperatur von 470°C bis 600°C erwärmt wird, wobei durch die Hilfsschicht (20) eine Strahlungsleistung P₂₀ von 10% bis 60% der einfallenden Strahlungsleistung P_{ges} absorbiert wird und,
c) das Glassubstrat (30) auf eine Temperatur von < 470°C abgekühlt wird.

14. Verfahren nach Anspruch 13, wobei die Hilfsschicht (20) auf das Glassubstrat (30), bevorzugt durch Aufdampfen, Kathodenstrahlzerstäubung und/oder chemische Gasphasenabscheidung, aufgebracht wird.

15. Verwendung einer Mehrschichtkörperanordnung (1) nach einem der Ansprüche 1 bis 12 zur Vermeidung der Verbiegung eines Glassubstrats (30) beim Überführen von mindestens einer Vorläuferschicht (13) in eine Halbleiterabsorberschicht einer Dünnschichtsolarzelle durch Wärmebehandlung und bevorzugt durch Rapid Thermal Processing.

## Claims

1. Multilayer body arrangement (1) for the prevention of glass substrate deformation, comprising:
- a multilayer body (2) having a glass substrate (30), a functional coating (10), which is applied on one side of the glass substrate (30), an auxiliary layer (20), which is areally connected to the side of the glass substrate (30) facing away from the functional coating (10), wherein the functional coating (10) includes precursor layers for conversion into a semiconductor layer of a thin-film solar cell,
- two emitter arrays (4) with a process level lying therebetween, in which the multilayer body (2) is disposed, with a radiated power Pₜₒₜ in the wavelength range from 250 nm to 4000 nm incident on the glass substrate (30) for heat-treating the functional coating (10),
wherein the auxiliary layer (20) has an absorbed radiated power P₂₀ from 10% to 60% of the incident radiated power Pₜₒₜ.

2. Multilayer body arrangement (1) according to claim 1, wherein the auxiliary layer (20) is applied on the glass substrate (30), preferably by vapor deposition, cathode sputtering, or electrochemical deposition.

3. Multilayer body arrangement (1) according to claim 1, wherein the auxiliary layer (20) is releasably connected to the glass substrate (30).

4. Multilayer body arrangement (1) according to claim 3, wherein the auxiliary layer (20) is applied on a carrier plate (40), preferably a base plate (41) or a cover plate (42) of a process box (50).

5. Multilayer body arrangement (1) according to one of claims 1 through 4, wherein the auxiliary layer (20) has an absorbed radiated power P₂₀ from 10% to 40% and preferably from 20% to 30% of Pₜₒₜ.

6. Multilayer body arrangement (1) according to one of claims 1 through 5, wherein the auxiliary layer (20) has an absorbed radiated power P₂₀ from 50% to 150% and preferably from 75% to 125% of the radiated power P₁₀ absorbed in the functional coating (10).

7. Multilayer body arrangement (1) according to one of claims 1 through 6, wherein the auxiliary layer (20) includes at least one layer made of graphite, silicon carbide, and/or boron nitride, preferably with a layer thickness of 10 nm to 10 µm.

8. Multilayer body arrangement (1) according to one of claims 1 through 7, wherein the auxiliary layer (20) includes an absorption layer (23) disposed on the glass substrate (30) and a protective layer (22) disposed on the absorption layer (23).

9. Multilayer body arrangement (1) according to one of claims 1 through 8, wherein the absorption layer (23) includes a metal, preferably aluminum, molybdenum, copper, cobalt, nickel, titanium, and/or tantalum, or a metalloid compound, preferably silicon carbide, zinc oxide, cadmium sulfide, cadmium telluride, indium antimonide, indium arsenide, and/or zinc antimonide, and/or the protective layer (22) contains silicon nitride, titanium nitride, molybdenum nitride, aluminum oxide, and/or aluminum nitride.

10. Multilayer body arrangement according to one of claims 1 through 9, wherein the auxiliary layer (20) has an adhesive layer (21) between the glass substrate (30) and the absorption layer (23) and the adhesive layer (21) preferably includes silicon nitride and/or silicon oxynitride.

11. Multilayer body arrangement according to one of claims 1 through 10, wherein the precursor layers (13,14) contain copper, indium, gallium, sulfur, and/or selenium.

12. Multilayer body arrangement according to one of claims 1 through 11, wherein the functional coating (10) includes at least one barrier layer (11), preferably a silicon nitride layer with a thickness of 50 nm to 300 nm, an electrode (12), preferably a molybdenum layer with a thickness of 200 nm to 700 nm, a precursor layer (13), preferably a copper-indium-gallium-layer with a thickness of 300 nm to 1000 nm, and an additional precursor layer (14), preferably a selenium layer with a thickness of 700 nm to 2000 nm.

13. Method for heat-treating with a multilayer body arrangement (1) according to one of claims 1 through 12, wherein
a) a functional coating (10) is applied on one side of a glass substrate (30), and the side of the glass substrate (30) facing away from the functional coating (10) is connected to an auxiliary layer (20),
b) the glass substrate (30) is arranged in a process level lying between two emitter arrays (4) and is heated to a temperature of 470°C to 600°C by at least one emitter array (4) with a radiated power Pₜₒₜ in the wavelength range from 250 nm to 4000 nm incident on the glass substrate (30), wherein a radiated power P₂₀ von 10% to 60% of the incident radiated power Pₜₒₜ is absorbed by the auxiliary layer (20), and,
c) the glass substrate (30) is cooled to a temperature of < 470°C.

14. Method according to claim 13, wherein the auxiliary layer (20) is applied on the glass substrate (30), preferably by vapor deposition, cathode ray sputtering, and/or chemical gas phase deposition.

15. Use of a multilayer body arrangement (1) according to one of claims 1 through 12 for the prevention of deformation of a glass substrate (30) during conversion of at least one precursor layer (13) into a semiconductor absorber layer of a thin-film solar cell by heat treatment and preferably by rapid thermal processing.

## Revendications

1. Arrangement de corps multicouche (1) pour empêcher la déformation d'un substrat en verre, comprenant :
- un corps multicouche (2) avec un substrat en verre (30), un revêtement fonctionnel (10) appliqué sur une face du substrat en verre (30) et une couche auxiliaire (20) qui est reliée sur toute sa surface à la face du substrat en verre (30) détournée du revêtement fonctionnel (10), où le revêtement fonctionnel (10) contient des couches précurseurs pour le transfert dans une couche semi-conductrice d'une cellule solaire à couches minces,
- deux champs de radiation (4) avec un niveau de processus intermédiaire où est disposé le corps multicouche (2), avec une puissance de rayonnement P_{ges} incidente sur le substrat en verre (30) dans la plage de longueur d'onde de 250 nm à 4000 nm pour le traitement thermique du revêtement fonctionnel (10),
où la couche auxiliaire (20) présente une puissance de rayonnement absorbée P₂₀ de 10 % à 60 % de la puissance de rayonnement incidente P_{ges}.

2. Arrangement de corps multicouche (1) selon la revendication 1, où la couche auxiliaire (20) est déposée sur le substrat en verre (30), de préférence par dépôt en phase vapeur, pulvérisation cathodique ou dépôt électrochimique.

3. Arrangement de corps multicouche (1) selon la revendication 1, où la couche auxiliaire (20) est reliée de manière amovible au substrat en verre (30).

4. Arrangement de corps multicouche (1) selon la revendication 3, où la couche auxiliaire (20) est appliquée sur une plaque de support (40), de préférence une plaque de fond (41) ou une plaque de couverture (42) d'une boîte de traitement (50).

5. Arrangement de corps multicouche (1) selon l'une quelconque des revendications 1 à 4, où la couche auxiliaire (20) a une puissance de rayonnement absorbée P₂₀ de 10 % à 40 % et de préférence de 20 % à 30 % de P_{ges}.

6. Arrangement de corps multicouche (1) selon l'une des revendications 1 à 5, où la couche auxiliaire (20) présente une puissance de rayonnement absorbée P₂₀ de 50% à 150% et de préférence de 75% à 125% de la puissance de rayonnement P₁₀ absorbée dans le revêtement fonctionnel (10).

7. Arrangement de corps multicouche (1) selon l'une des revendications 1 à 6, où la couche auxiliaire (20) comprend au moins une couche de graphite, de carbure de silicium et/ou de nitrure de bore, de préférence avec une épaisseur de couche de 10 nm à 10 µm.

8. Arrangement de corps multicouche (1) selon l'une des revendications 1 à 7, où la couche auxiliaire (20) comprend une couche d'absorption (23) disposée sur le substrat en verre (30) et une couche de protection (22) disposée sur la couche d'absorption (23).

9. Arrangement de corps multicouche (1) selon l'une des revendications 1 à 8, où la couche d'absorption (23) comprend un métal, de préférence de l'aluminium, du molybdène, du cuivre, du cobalt, du nickel, du titane et/ou du tantale, ou un composé semi-métallique, de préférence du carbure de silicium, de l'oxyde de zinc, du sulfure de cadmium, du tellurure de cadmium, de l'antimoniure d'indium, de l'arséniure d'indium et/ou de l'antimoniure de zinc, et/ou la couche protectrice (22) contient du nitrure de silicium, du nitrure de titane, du nitrure de molybdène, de l'oxyde d'aluminium et/ou du nitrure d'aluminium.

10. Arrangement de corps multicouche selon l'une des revendications 1 à 9, où la couche auxiliaire (20) présente une couche adhésive (21) entre le substrat de verre (30) et la couche d'absorption (23) et la couche adhésive (21) contient de préférence du nitrure de silicium et/ou de l'oxynitrure de silicium.

11. Arrangement de corps multicouche selon l'une des revendications 1 à 10, où le revêtement fonctionnel (10) contient des couches précurseurs (13, 14) de cuivre, d'indium, de gallium, de soufre et/ou de sélénium.

12. Arrangement de corps multicouche selon l'une des revendications 1 à 11, où le revêtement fonctionnel (10) comprend au moins une couche barrière (11), de préférence une couche de nitrure de silicium d'une épaisseur de 50 nm à 300 nm, une électrode (12), de préférence une couche de molybdène d'une épaisseur de 200 nm à 700 nm, une couche précurseur (13), de préférence une couche de cuivre-indium-gallium d'une épaisseur de 300 nm à 1000 nm et une autre couche précurseur (14), de préférence une couche de sélénium d'une épaisseur de 700 nm à 2000 nm.

13. Procédé de traitement thermique avec un arrangement de corps multicouche (1) selon l'une des revendications 1 à 12, où
a) un revêtement fonctionnel (10) est appliqué sur une face d'un substrat de verre (30) et la face du substrat de verre (30) détournée du revêtement fonctionnel (10) est reliée à une couche auxiliaire (20), où le revêtement fonctionnel (10) contient des couches précurseurs pour le transfert dans une couche semi-conductrice d'une cellule solaire à couches minces,
b) le substrat de verre (30) est disposé dans un niveau de processus situé entre deux champs de rayonnement (4) et est chauffé à une température de 470°C à 600°C avec une puissance de rayonnement P_{ges} dans la plage de longueur d'onde de 250 nm à 4000 nm incidente sur le substrat de verre (30), où une puissance de rayonnement P₂₀ de 10% à 60% de la puissance de rayonnement incidente P_{ges} est absorbée par la couche auxiliaire (20) et,
c) le substrat de verre (30) est refroidi à une température inférieure à 470°C

14. Procédé selon la revendication 13, où la couche auxiliaire (20) est appliquée sur le substrat en verre (30), de préférence par dépôt de vapeur, pulvérisation cathodique et/ou dépôt chimique en phase vapeur.

15. Utilisation d'un arrangement de corps multicouche (1) selon l'une des revendications 1 à 12 pour éviter la déformation d'un substrat en verre (30) lors du transfert d'au moins une couche précurseur (13) dans une couche d'absorption semi-conductrice d'une cellule solaire à couches minces par traitement thermique et de préférence par traitement thermique rapide (RTP).
